(19) Europäisches Patentamt
European Patent Office
Office européen des brevets

(11) **EP 1 687 902 B1**

(12) **EUROPEAN PATENT SPECIFICATION**

(45) Date of publication and mention
of the grant of the patent:
**24.10.2007 Bulletin 2007/43**

(21) Application number: **04803258.5**

(22) Date of filing: **24.11.2004**

(51) Int Cl.:
*H03M 13/11* *(2006.01)*

(86) International application number:
**PCT/EP2004/013343**

(87) International publication number:
**WO 2005/053164 (09.06.2005 Gazette 2005/23)**

(54) **BELIEF PROPAGATION DECODER CANCELLING THE EXCHANGE OF UNRELIABLE MESSAGES**

BELIEF-AUSBREITUNGSDECODIERER, DER DEN AUSTAUSCH UNZUVERLÄSSIGER NACHRICHTEN AUFHEBT

DECODEUR PAR PROPAGATION DE CROYANCES SUPPRIMANT L'ECHANGE DE MESSAGES NON FIABLES

(84) Designated Contracting States:
**DE**

(30) Priority: **26.11.2003 EP 03027341**

(43) Date of publication of application:
**09.08.2006 Bulletin 2006/32**

(73) Proprietor: **MATSUSHITA ELECTRIC INDUSTRIAL CO., LTD.**
**Osaka 540-6319 (JP)**

(72) Inventors:
• **GOLITSCHEK EDLER VON ELBWART, Alexander**
**64285 Darmstadt (DE)**
• **WENGERTER, Christian**
**63924 Kleinheubach (DE)**

(74) Representative: **Grünecker, Kinkeldey, Stockmair & Schwanhäusser**
**Anwaltssozietät**
**Maximilianstrasse 58**
**80538 München (DE)**

(56) References cited:
WO-A-02/37731          WO-A-03/032499
CA-A- 2 310 186

• NOUH A ET AL: "Bootstrap decoding of low-density parity-check codes" IEEE COMMUNICATIONS LETTERS, IEEE SERVICE CENTER, PISCATAWAY,US, US, vol. 6, no. 9, September 2002 (2002-09), pages 391-393, XP001128483 ISSN: 1089-7798
• MAO Y ET AL: "Decoding low-density parity-check codes with probabilistic scheduling" IEEE COMMUNICATIONS LETTERS, IEEE SERVICE CENTER, PISCATAWAY,US, US, vol. 5, no. 10, October 2001 (2001-10), pages 414-416, XP001110789 ISSN: 1089-7798
• YIN LIUGUO ET AL: "Modified belief-propagation algorithm for decoding of irregular low-density parity-check codes" ELECTRONICS LETTERS, IEE STEVENAGE, GB, vol. 38, no. 24, 21 November 2002 (2002-11-21), pages 1551-1553, XP006019345 ISSN: 0013-5194
• KSCHISCHANG F R ET AL: "Factor graphs and the sum-product algorithm" IEEE TRANSACTIONS ON INFORMATION THEORY, IEEE INC. NEW YORK, US, vol. 47, no. 2, February 2001 (2001-02), pages 498-519, XP001009659 ISSN: 0018-9448

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

### Field of the Invention

The present invention relates to a method for decoding at least one codeword comprising N code bits in a decoder. The codeword having been generated in an encoder using a set of M parity equations presentable as a parity check matrix. Further, the present invention relates to a decoder as well as to a mobile terminal and base station employing the decoder. Moreover, the present invention relates to a communication system in which a mobile station and/or a base station according to the invention is/are used.

### Related Art

*Low-Density Parity-Check Coding*

Error correcting codes are widely utilized to obtain reliable communications over noisy channels. Generally speaking, a linear error correcting code C can be described by a parity-check matrix H satisfying Hx = 0 for any codeword xe C. H is an M x N matrix where N is the size of a codeword and M is the number of linear constraints that must be satisfied by each code word. Each row of H therefore represents a linear homogeneous parity-check equation.

Low-density parity-check (LDPC) codes are a particular class of linear error correcting codes characterized by a highly sparse parity check matrix. Typically, in a matrix having a relatively large row length, the entire row may consist of just three ones, the remainder being zeroes. The number of ones in a row m is also called the *row weight* $\rho_m$, while the number of ones in a column n is called the *column weight* $\chi_n$. If row weight and column weight are independent of the particular row or column, i.e. $\rho_m=\rho$ and $\chi_n=\chi$ for all m and n, the code determined by H is called a *regular* code. Otherwise it is called an *irregular* code.

LDPC codes were originally introduced and investigated by Gallager in 1962, (see Gallager, "Low-density parity-check codes", IRE Transactions on Information Theory, Vol. IT-8, pp. 21-28, 1962). A problem of using low density parity check matrices has been to provide a method of decoding, and one of the most significant features of Gallager's work is the introduction of iterative decoding algorithms. He showed that, when applied to sparse parity-check matrices, such algorithms are capable of achieving a significant fraction of the channel capacity in a communication system at relatively low complexity. Furthermore, the number of computations per bit per iteration is independent of the block length N.

Since Gallager's prominent contribution, LDPC codes have been rediscovered and further investigated by Tanner, Wiberg, MacKay and Neal and others. Details of these investigations may be found in Tanner, "A recursive approach to low complexity code", IEEE Transactions on Information Theory, pp. 533-547, 1981, and MacKay et al., "Near Shannon limit performance of Low-Density Parity-Check Codes", IEEE Electronic Letters, vol. 32, pp. 1645-1646, 1996.

*Belief Propagation*

Known decoders include the maximum likelihood decoder and the maximum a-posteriori decoder. The more widely used of the two, the maximum-likelihood decoder involves finding a most probable information word (where the likelihood is dependent on the channel model). The maximum a-posteriori decoder differs from the maximum likelihood decoding in that it provides an a *posteriori* probability for each symbol. A problem, however, is that the maximum a-posteriori decoder is typically computationally more complex than the maximum-likelihood decoder.

Gallager therefore proposed the iterative decoding scheme referred to above, based on the (later termed) belief propagation method, which approximately converges to the a *posteriori* probability of each symbol.

The method relies on a graph-based representation of codes, where the decoding can be understood as message passing in a factor graph. Belief propagation produces exact probabilities in case of a non-cyclic graph. Unfortunately, the graph associated with an LDPC code is usually cyclic and therefore belief propagation may produce inaccurate probabilities. Nevertheless, Gallager's decoding algorithm gives good empirical performance since, in particular, the end product is the decoding, and so the posterior probabilities need not necessarily be exact.

*Sum-Product Algorithm*

A brief description of the sum-product iterative algorithm follows. For brevity of exposition, we consider the binary case. The extension to the non-binary case should impose no problem to those skilled in the art, and can be found for example in Davey et al, "Low-Density Parity Check Codes for GF(q)", IEEE Communications Letters, Vol. 2, No. 6, June 1998. Based on the finding that LDPC codes provide a near-Shannon performance when decoded using a probabilistic decoding algorithm, Davey et al. present empirical results of error-correction using the analogous codes over a Galois Field GF(q) for q>2 for different channel models.

More detailed discussion about graphs and the sum-product algorithm, as well as further simplifications for binary variables and parity checks, can be found in Kschischang et al., "Factor Graphs and the Sum-Product Algorithm", IEEE Transactions on Information Theory, Vol. 47, No. 2, February 2001. Kschischang et al. disclose a generic message passing algorithm, the sum-product algorithm, operating in a factor graph. A factor graph is a bipartite graph visualizing the factorization of complicated global functions of many variables.

A simplifying characteristic of the binary case is that since there are only two possible events, the event probabilities can be expressed in terms of a log-likelihood ratio (LLR), which is generally defined by

$$LLR = \ln \frac{p(x=1)}{p(x=0)} = \ln \frac{p(x=1)}{1 - p(x=1)} \qquad (1)$$

as the natural logarithm of the ratio of probabilities that x is one of the two possible events.

The algorithm has two alternating components commonly referred to as the horizontal and vertical steps. More specifically, two binary distributions or message matrices, $\alpha_{mn}$ and $\beta_{mn}$ associated with the non-zero elements $h_{mn}$ of the sparse parity-check matrix H, are iteratively updated. The quantity $\alpha_{mn}$ represents the LLR of the $n$th bit of the transmitted codeword given the information obtained from all the parity equations other than the $m$th equation. In a similar manner, $\beta_{mn}$ represents the LLR for the satisfaction of the $m$th parity-check equation given the LLR of the $n$th bit and all the other bits are statistically independent, with associated distributions $\beta_{m1}...\beta_{mN}$. Assuming that the codewords are used with equal probability on an arbitrary binary-input continuous-output channel, the sum-product algorithm can be described as follows.

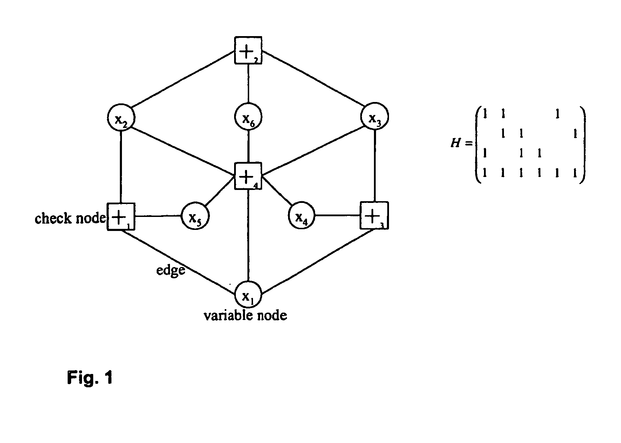

Before summarizing the algorithm, some terms used in the following sections are defined first. The terms are described within the error decoding context. Fig. 1 shows a sample parity-check matrix H, together with a graph representation of the matrix which may be used to confer the following definitions.

A Check Node represents one parity check bit. A parity check bit is generally computed from one or more information bits such that a given equation is solved. In binary logic, an equation might be represented by the modulo-2 sum of information bits, where the results should be equal to the parity check bit.

A Variable Node represents one coded bit. In communication decoding a coded bit is usually equivalent to the received value of a code bit, or for example a log-likelihood ratio. A Variable Node is connected to one or more Check Nodes, which represents the relation of that variable to the respective parity check bit. In other words, a variable participates in all the equations of connected Check Nodes.

An edge between a Variable Node and a Check Node is used to represent a relation between these. On the Variable Node side the edges to Check Nodes give information which check equations involve that variable. On the Check Node side the edges to Variable Nodes give information which variables are involved in that particular parity check equation.

In the decoding process a message is passed along the edges from Variable Node to Check Node, and also from Check Node to Variable Node. The message typically contains some sort of belief or probability information (hence "belief propagation" is widely used in literature).

The Sum-Product algorithm may be defined by the following steps:

*Initialization*

$\lambda_n$ represents the a priori LLR of the $n$th bit of the transmitted codeword. This LLR can be calculated from the received vector corresponding to the transmitted codeword and the channel model. For each non-zero entry $h_{mn}$ of the parity-check matrix H, set:

$$\alpha_{mn} = \lambda_n \qquad (2)$$

*Horizontal step*

For each non-zero entry $h_{mn}$ of the matrix H, $\beta_{mn}$ is computed using the equation:

$$\beta_{mn} = 2 \cdot \tanh^{-1} \prod_{\substack{l=1..N \\ l \neq n}} \tanh \frac{\alpha_{ml}}{2} \qquad (3)$$

where $l$ runs over the non-zero bit positions of the $m^{th}$ parity equation (i.e. $h_{ml} \neq 0$), excluding the $n^{th}$ position.

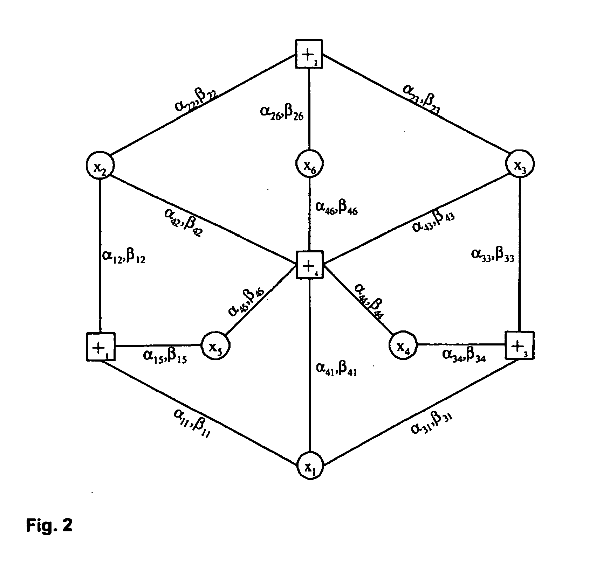

Fig. 2 shows a graph representation of an exemplary parity check matrix

$$H = \begin{pmatrix} 1 & 1 & 0 & 0 & 1 & 0 \\ 0 & 1 & 1 & 0 & 0 & 1 \\ 1 & 0 & 1 & 1 & 0 & 0 \\ 1 & 1 & 1 & 1 & 1 & 1 \end{pmatrix}.$$

The horizontal step can be visualized according to Fig. 2 as follows. Whenever a $\beta_{mn}$ is to be calculated for a given edge mn connecting Check Node m to Variable Node n, all $\alpha$ values on edges are involved which are connected to Check Node m except the $\alpha$ value which belongs to edge mn, i.e. $\alpha_{mn}$.

*Vertical Step*

For each non-zero entry $h_{mn}$ of the matrix H, update $\alpha_{mn}$ in the following manner:

$$\alpha_{mn} = \lambda_n + \sum_{\substack{j=1..M \\ j \neq m}} \beta_{jn} \qquad (4)$$

where $j$ runs over the parity equations for which $h_{jn} \neq 0$.

*Decoding*

A single iteration typically consists of an application of the horizontal step and then of an application of the vertical step (except for the first iteration where additionally $\alpha_{mn}$ is initialized based on the symbols received from the channel). At the end of any iteration (including the initialization step) one can also update the soft-output decision (i.e. the estimated posteriori LLR $\xi_n$) of each bit:

$$\xi_n = \lambda_n + \sum_{j=1..M} \beta_{jn} \qquad (5)$$

where $j$ runs over the parity equations for which $h_{jn} \neq 0$. Using equation (5) the value of the $k$th transmitted bit can be estimated as

$$\hat{x}_k = \begin{cases} 1 & \text{if } \xi_n \geq 0 \\ 0 & \text{if } \xi_n < 0 \end{cases} = \begin{cases} 1 & \text{if } \lambda_n + \sum_{j=1..M} \beta_{jn} \geq 0 \\ 0 & \text{if } \lambda_n + \sum_{j=1..M} \beta_{jn} < 0 \end{cases} \qquad (6)$$

In this manner a tentative bit-by-bit decoding is performed and a vector x is obtained. If Hx=0, i.e. if $\xi$ is a codeword, the decoding algorithm halts declaring x as the output. Otherwise, the iterative process continues by returning to the horizontal step above. The decoding procedure terminates by declaring a decoding-failure, or if some maximum predetermined number of iterations (e.g. 100) occurs with no successful decoding.

*Min-Sum Algorithm*

To simplify the calculations involved, equation (3) In the horizontal step, may be approximated and substituted by

$$\beta_{mn} = \min_{\substack{l=1..N \\ l \neq n}}(|\alpha_{ml}|) \cdot \prod_{\substack{l=1..N \\ l \neq n}} \text{sgn}(\alpha_{ml}) \qquad (7)$$

This approximation will degrade the performance of the decoding however.

WO 02/37731 A2 provides an implementation of the sum-product algorithm which uses different sets of equations to achieve the horizontal step, vertical step, and decoding. More particularly, the reference employs a likelihood difference as also defined by Kschischang et al. to perform the calculations of the horizontal and vertical step.

As can be seen from the equations above for the horizontal step, vertical step, and decoding, the information from numerous values is involved which is ultimately derived from the received vector corresponding to the transmitted codeword. In a noisy channel environment, chances are high that several received values (bits) carry wrong information, which implies that wrong information can be Inferred from these values and propagate through the decoding iterations.

The article of Nouh et al., "Bootstrap Decoding of Low Density Parity-Check Codes", IEEE Communications Letters, Vol. 6, No. 9, September 2002, proposes an initial bootstrap step for the decoding of Low-Density Parity-Check (LDPC) codes. Decoding is initiated by first erasing a number of less reliable bits. New values and reliabilites are then assigned to erasure bits by passing messages from nonerasure bits through the reliable check equations. The bootstrap step is applied to the weighted bit-flipping algorithm to decode a number of LDPC codes.

**Summary of the Invention**

It is therefore the object of the present invention to reduce the influence of wrong information in an iterative decoding method.

The object of the present invention is solved by the subject matter of the independent claims. Preferred embodiments of the present invention are subject matter to the dependent claims.

In the following, the terminology used in the introduction and by Kschischang et al. has been retained to facilitate the comprehension of the present invention. According to the present invention a message matrix may be a rectangular matrix which holds generally real values representing the messages about a certain coded symbol. The message itself may be a knowledge-related, belief-related, or probability-related measure. Generally the position within the matrix gives information about the concerned coded symbol, as well as about how the message is obtained. In a preferred embodiment the row index denotes the parity check equation which is relevant for the message, while the column gives information about the coded symbol for which the message is valid.

According to an embodiment of the present invention a method for decoding at least one codeword *x* comprising N code bits in a decoder is provided. The codeword x may have been generated in an encoder using a set of M parity equations presentable as a parity check matrix *H.* In other words, the decoding is performed as message passing on a graph representation of the used code, wherein the graph representation is based on a parity check matrix.

According to the method, for each non-zero entry in a parity check matrix H , the elements $\alpha_{mn}$ of a first message matrix may be initialized with data $\lambda_n$ obtained from a demodulator. Next, for each non-zero entry in the parity check matrix H , the elements $\beta_{mn}$ of a second message matrix may be determined based on elements $\alpha_{mn}$ of said first message matrix, and a decoded codeword $\hat{x}$ may be reconstructed based on the data $\lambda_n$ obtained from the demodulator and the elements $\beta_{mn}$ of the second message matrix.

According to this embodiment, only a subset of message matrix elements $\alpha_{mn}$ from said first message matrix may be used for determining a message matrix element $\beta_{mn}$ of said second message matrix, wherein the message matrix elements of said subset fulfill a reliability criterion.

According to the method, only reliable message matrix elements of the first message matrix, e.g. the elements $\alpha_{mn}$, may be used to determine the message matrix elements $\beta_{mn}$ of a second matrix. Taking the example of the Sum-Product algorithm as outlined above, in any of the equations of the horizontal step and/or vertical step, not all information may be processed. Instead some of the values, i.e. message matrix elements may be excluded from the calculations. Which values are excluded may be determined according to criteria as outlined further down below. Generally a value may be excluded if it is unreliable such that the inclusion of the term would produce worse results than its omission from the respective equation.

Further, the message matrix elements $\alpha_{mn}$ of the first message matrix may be updated based on a subset of message matrix elements $\beta_{mn}$ of said second message matrix, wherein the message matrix elements of said subset fulfill a reliability criterion. This may for example be applicable in case it has been decided to perform several iterations before trying to decode a codeword. Hence, when considering the example of the Sum-Product algorithm again, the calculations of the $\alpha_{mn}$ values in the vertical step may be performed on a reduced set of elements $\beta_{mn}$.

In the embodiment above only the message matrix elements $\beta_{mn}$ of the second message matrix may be updated. According to a further embodiment it is also possible to update only the message matrix elements $\alpha_{mn}$ based on a reduced set, i.e. a subset of message matrix elements $\beta_{mn}$.

Therefore, the present invention further provides a method for decoding at least one codeword $x$ comprising N code bits in a decoder wherein the codeword x may have been generated in an encoder using a set of M parity equations presentable as a parity check matrix $H$. According to this embodiment, for each non-zero entry in a parity check matrix $H$, the elements $\alpha_{mn}$ of a first message matrix may be initialized with data $\lambda_n$ obtained from a demodulator. Next, for each non-zero entry in the parity check matrix $H$, the elements $\beta_{mn}$ of a second message matrix may be determined based on elements $\alpha_{mn}$ of said first message matrix, and a decoded codeword $\hat{x}$ may be reconstructed based on the data $\lambda_n$ obtained from the demodulator and the elements $\beta_{mn}$ of the second message matrix. Further, for each non-zero entry in the parity check matrix $H$, the message matrix elements $\alpha_{mn}$ of the first message matrix may be updated based on message matrix elements $\beta_{mn}$ of the second message matrix, wherein a subset of message matrix elements $\beta_{mn}$ of said second message matrix may be used to update a message matrix element $\alpha_{mn}$ of said first message matrix, wherein the message matrix elements of said subset fulfill a reliability criterion.

According to a further embodiment of the present invention, only a subset of message matrix elements $\alpha_{mn}$ of said first message matrix is used for determining a message matrix element $\beta_{mn}$ of said second message matrix, wherein the message matrix elements of said subset fulfill a reliability criterion.

In another embodiment, the elements of the first and/or the second message matrix may be recalculated in several iterations before the decoding method tries to decode the received code bits for the first time. Hence, the method proposed may further comprise the step of performing iterations by repeating the determination of the message matrix elements $\beta_{mn}$ of the second message matrix.

In a further embodiment, it may be repeatedly tried to decode the code bits received. Thus, the iterations may further comprise reconstructing a decoded codeword $\hat{x}$ based on the data $\lambda_n$ obtained from the demodulator and the elements $\beta_{mn}$ of the second message matrix in each iteration.

In order to determine, whether the reconstructed codeword is a valid codeword, it may be checked whether the parity check equations of the parity-check matrix H are satisfied by the reconstructed decoded codeword $\hat{x}$.

The iteration through the different processing steps as outlined above may be stopped upon reaching on predetermined number of iterations or in case the decoded codeword $\hat{x}$ satisfies the parity check equations.

In another embodiment of the present invention, the data obtained from a demodulator may comprise parameters representing one of a likelihood ratio, a likelihood difference or a probability for each of the N code bits of a codeword $x$. Thus, different measures or parameters may be used in the proposed method to calculate the different elements of the first and second message matrix.

Further, the data obtained from the demodulator may further comprise indications which of the parameters provided fulfill the reliability criterion.

According to a further embodiment of the present application, the subset of message matrix elements $\beta_{mn}$ of said second message matrix used to determine the message matrix elements $\alpha_{mn}$ of said first message matrix may be updated upon determining new message matrix elements $\beta_{mn}$ in an iteration step. This allows adapting the decoding method to a possibly redefined reliability criterion in each iteration step.

When updating the subset, the updated subset may therefore only comprise message matrix elements $\beta_{mn}$ of the second message matrix fulfilling a reliability criterion, e.g. a criterion updated during the different possible iterations in the decoding process.

In another embodiment of the present invention also the subset of message matrix elements $\alpha_{mn}$ of said first message matrix used to determine the message matrix elements $\beta_{mn}$ of said second message matrix may be updated upon determining new message matrix elements $\alpha_{mn}$ in an iteration step.

When updating the subset, the updated subset may comprise only message matrix elements $\alpha_{mn}$ of the first message matrix fulfilling the reliability criterion.

According to a further embodiment, the reliability criterion may be based on at least one of channel estimations of a radio channel via which the codeword x has been received, the absolute values of the elements of the first and/or second message matrix, the absolute values of the data provided by the demodulator, the number of the iteration in the decoding which have already been processed, the maximum number of iterations to be performed in the decoding process, and a random process.

It may be determined that the reliability criterion is not fulfilled by a message matrix element of the first or the second message matrix, if the signal to noise ratio for the element and/or the absolute value of the element is below a predetermined threshold value.

According to this embodiment, it may be for example possible, to use the channel estimations of the radio channel as a basis for deciding which of the initialized message matrix elements $\alpha_{mn}$ of the first message matrix are added to the subset used to determined the message matrix elements $\beta_{mn}$ of the second message matrix. Next, when updating either the first or second message matrix or both, the absolute value of individual message matrix elements may build the basis for the reliability criterion to define the subset for updating. Also the number of iterations already performed may influence the reliability criterion.

In a further embodiment of the present invention, the error correcting code used is a low-density parity-check (LDPC) code.

Another embodiment of the present invention is related to a decoder. The decoder may be used for decoding at least one codeword x and may comprise processing means for initializing the elements $\alpha_{mn}$ of a first message matrix for each non-zero entry in a parity check matrix $H$ with data $\lambda_n$ obtained from a demodulator, for determining the elements $\beta_{mn}$ of a second message matrix for each non-zero entry in the parity check matrix $H$, based on elements $\alpha_{mn}$ of said first message matrix, and for reconstructing a decoded codeword $\hat{x}$ based on the data $\lambda_n$ obtained from the demodulator and the elements $\beta_{mn}$ of the second message matrix.

Moreover, the processing means may be further adapted to use a subset of message matrix elements $\alpha_{mn}$ from said first message matrix for determining a message matrix element $\beta_{mn}$ of said second message matrix, wherein the message matrix elements of said subset fulfill a reliability criterion.

According to an alternative embodiment of the present invention, a decoder for decoding at least one codeword x may comprise processing means for initializing the elements $\alpha_{mn}$ of a first message matrix for each non-zero entry in a parity check matrix $H$ with data $\lambda_n$ obtained from a demodulator, for determining the elements $\beta_{mn}$ of a second message matrix for each non-zero entry in the parity check matrix $H$, based on elements $\alpha_{mn}$ of said first message matrix, and for reconstructing a decoded codeword $\hat{x}$ based on the data $\lambda_n$, obtained from the demodulator and the elements $\beta_{mn}$ of the second message matrix, and for updating the message matrix elements $\alpha_{mn}$ of the first message matrix for each non-zero entry in the parity check matrix H based on message matrix elements $\beta_{mn}$ of the second message matrix.

Further the processing means may be adapted to use a subset of message matrix elements $\beta_{mn}$ of said second message matrix to update a message matrix element $\alpha_{mn}$ of said first message matrix, wherein the message matrix elements of said subset fulfill a reliability criterion.

The two alternative implementations of the decoder mentioned above may be further adapted to perform the decoding methods described above.

In other embodiments, the present invention provides a mobile terminal and a base station in a mobile communication system, both comprising receiving means for receiving at least one codeword x, demodulation means for demodulating the at least one received codeword x and for delivering data to a decoder, and the decoder according to one of the various embodiments described above.

The mobile terminal and/or the base station may further comprise coding means for encoding data in at least one codeword x, and transmission means for transmitting the at least one codeword *x*, and in that at least one transmitted codeword x is suitable for decoding according to the different decoding methods described above.

Moreover the present invention further provides a mobile communication system comprising at least one base station and at least one mobile terminal.

**Brief Description of the Figures**

In the following the present invention is described in more detail in reference to the attached figures and drawings. Similar or corresponding details in the figures are marked with the same reference numerals.

**Fig. 1**     shows a sample parity-check matrix H, together with a graph representation of the matrix,

**Fig. 2**     shows the graph representation of Fig. 1 together with the messages $\alpha_{mn}$ and $\beta_{mn}$ which are passed along the edges in belief propagation algorithms,

**Fig. 3**     shows a flow chart of an exemplary decoding process according to an embodiment of the present invention,

**Fig. 4**     shows a flow chart of another exemplary decoding process according to an embodiment of the present invention,

**Fig. 5**     shows a transmitter and a receiver unit according to an embodiment of the present invention,

**Fig. 6**     shows a mobile terminal according to an embodiment of the present invention comprising the transmitter and the receiver shown in Fig. 5,

**Fig. 7**     shows a base station according to an embodiment of the present invention comprising the transmitter and the receiver shown in Fig. 5, and

**Fig. 8**     shows an architectural overview of a communication system according to an embodiment of the present invention comprising a mobile terminal shown in Fig. 6 and a base station (Node B) shown in Fig. 7.

**Detailed Description**

In the following description of the different embodiments of the present invention the expression "$\chi \in A \backslash B$" denotes "x is element of set A without set B", which is equivalent to "x is element of set A but not element of set B". Further, the following paragraphs will outline the ideas underlying the present invention by way of example considering LDPC decoding. However, it should be noted that the principles underlying the present invention may also be applicable to other codes.

As outlined before, mathematical equations may be solved in the horizontal step, vertical step, and decision step. At least the horizontal step and vertical step equations are computed in each iteration, such that it would be formally correct to refer to e.g. $\alpha_{mn}^{(i)}$ and $\beta_{mn}^{(i)}$, where $i$ represents the iteration number, and the initialization step for $\alpha_{mn}$ may be interpreted as iteration number zero, i.e. $\alpha_{mn}^{(0)}$. However for sake of simplicity and brevity an iteration superscript has been omitted from the formulas.

Generally, it should be noted that $\alpha$ values are necessary to compute $\beta$ values in the horizontal step. Likewise it should be noted that $\beta$ values are necessary to compute $\alpha$ values in the vertical step as well as to compute $\xi$ values in the decoding process.

A new $\beta_{mn}$ value, i.e. a new message matrix element, is computed from $\alpha_{ml}$ values where $l$ takes all values from 1 to N where the parity-check matrix entry $h_{ml}$ is not zero, except n. This can be interpreted as $l$ being element of a set $L_{mn}$.

$$L_{mn} = \left\{ l \in [1, n-1] \cup [n+1, N] \middle| h_{ml} \neq 0 \right\} \tag{8}$$

$L_{mn}$ represents the set of values $l \neq n$ between 1 and N for which $h_{ml} \neq 0$.

Using equation (8) the horizontal step may be reformulated:

$$\beta_{mn} = 2 \cdot \tanh^{-1} \prod_{l \in L_{mn}} \tanh \frac{\alpha_{ml}}{2} \tag{9}$$

or alternatively according to equation (7) approximated and simplified to

$$\beta_{mn} = \min_{l \in L_{mn}} \left( \left| \alpha_{ml} \right| \right) \cdot \prod_{l \in L_{mn}} \mathrm{sgn}\left( \alpha_{ml} \right) \tag{10}$$

Similarly there may exist a vertical step set $J_{mn}$ which can be defined as follows:

$$J_{mn} = \left\{ j \in [1, m-1] \cup [m+1, M] \middle| h_{jn} \neq 0 \right\} \tag{11}$$

$J_{mn}$ may be interpreted as a set of values $j \neq m$ between 1 and M for which $h_{jn} \neq 0$. With equation (11) the vertical step can be rewritten as

$$\alpha_{mn} = \lambda_n + \sum_{j \in J_{mn}} \beta_{jn} \qquad\qquad (12)$$

According to the present invention, exclusion sets $\Gamma_{mn}$ and $\Omega_{mn}$ may be defined for the horizontal and vertical steps. The exclusion set may comprise message matrix elements which are not considered when determining or updating the message matrix elements $\alpha_{mn}$ of the vertical step and/or the message matrix coefficients $\beta_{mn}$ of the horizontal step.

A new horizontal step may be defined as:

$$\beta_{mn} = 2 \cdot \tanh^{-1} \prod_{l \in L_{mn} \backslash \Gamma_{mn}} \tanh \frac{\alpha_{ml}}{2} \qquad\qquad (13)$$

or alternatively approximated and simplified to

$$\beta_{mn} = \min_{l \in L_{mn} \backslash \Gamma_{mn}} \left(|\alpha_{ml}|\right) \cdot \prod_{l \in L_{mn} \backslash \Gamma_{mn}} \operatorname{sgn}(\alpha_{ml}) \qquad\qquad (14)$$

A new vertical step may be chosen as follows:

$$\alpha_{mn} = \lambda_n + \sum_{j \in J_{mn} \backslash \Omega_{mn}} \beta_{jn} \qquad\qquad (15)$$

If both sets $\Gamma_{mn}$ and $\Omega_{mn}$ are empty, prior art behavior is replicated. If $\Gamma_{mn}$ contains the same elements as $L_{mn}$ and/or $\Omega_{mn}$ contains the same elements as $J_{mn}$ for all possible values of m and n, the result would be no message propagation at all, which is equivalent to no decoding.

The situation where $\Gamma_{mn}$ contains the same elements as $L_{mn}$ may occur for arbitrary values of m and n. In such a case, the respective $\beta_{mn}$ values in the horizontal iteration step may be set to zero.

In case $\Gamma_{mn}$ contains the same elements as $L_{mn}$ for all values of m and n, all $\beta_{mn}$ values may be set to zero. Consequently the next vertical step may be interpreted as a reinitialization of the $\alpha_{mn}$ (see equation (15)), i.e. setting all $\alpha_{mn} = \lambda_n$. Thus, in such a case the decoded codeword $\hat{x}$ may correspond to a decision based directly on $\lambda_n$ (see equation (6)). From a technical point of view this may be regarded equivalent to not decoding the inputted data but to simply pass them to the next processing entity. It should be noted that in case $\Gamma_{mn}$ contains the same elements as $L_{mn}$ for all m and n, according to equation (15) the calculation of $\alpha_{mn}$ becomes independent from the exclusion set $\Omega_{mn}$, as any $\beta_{mn}$ element involved would have been set to zero. In this case also no effective message propagation among Nodes is performed.

Conversely, the initialization step may be viewed as an instance of a single new vertical step where the exclusion set $\Omega_{mn}$ contains the same elements as $J_{mn}$. Alternatively the initialization step may also be viewed as an instance of a single vertical step where all $\beta_{mn}$ values are equal to zero.

Generally the exclusion sets are depending on the reliability criteria, and therefore can depend on parameters such as the row index m for which an equation is solved, the column index n for which an equation is solved and/or the iteration i of the whole decoding algorithm. Further, the exclusion sets may be updated during the decoding process in dependence on decision criteria further outlined below.

As an example, in the horizontal step the message matrix element $\beta_{23}^{i}$ in iteration step i (see Fig. 2) may be determined by calculating

$$\beta_{23}^{i} = \min_{l \in L_{23}^{i} \setminus \Gamma_{23}^{i} = \{\}} \left( \left| \alpha_{2l}^{i-1} \right| \right) \cdot \prod_{l \in L_{23}^{i} \setminus \Gamma_{23}^{i} = \{\}} \mathrm{sgn}\left( \alpha_{2l}^{i-1} \right) = \min \left( \left| \alpha_{22}^{i-1} \right|, \left| \alpha_{26}^{i-1} \right| \right) \cdot \mathrm{sgn}\left( \alpha_{22}^{i-1} \right) \cdot \mathrm{sgn}\left( \alpha_{26}^{i-1} \right)$$

assuming that $\Gamma_{23}^{i}$ is empty and $L_{23}^{i} = \{2,6\}$. In case it is determined that a newly calculated $\alpha_{22}^{i}$ does not fulfill the reliability criterion, e.g. $\left| \alpha_{22}^{i} \right| < \alpha_{22}^{threshold}$, the exclusion set $\Gamma_{23}^{i}$ may be updated to $\Gamma_{23}^{i+1} = \{2\}$ in the next iteration $i+1$, such that the calculation of the new $\beta_{23}^{i+1}$ would only consider $\alpha_{26}^{i}$, i.e.

$$\beta_{23}^{i+1} = \min_{l \in L_{23}^{i+1} = \{2,6\} \setminus \Gamma_{23}^{i+1} = \{2\}} \left( \left| \alpha_{2l}^{i} \right| \right) \cdot \prod_{l \in L_{23}^{i+1} = \{2,6\} \setminus \Gamma_{23}^{i+1} = \{2\}} \mathrm{sgn}\left( \alpha_{2l}^{i} \right) = \left| \alpha_{26}^{i} \right| \cdot \mathrm{sgn}\left( \alpha_{26}^{i} \right) = \alpha_{26}^{i}$$

As can be seen in the example above, if the value $\alpha_{22}^{i}$ were unreliable, the resulting $\beta_{23}^{i+1}$ value could have been forged by the unreliable message matrix element $\alpha_{22}^{i}$. E.g. assuming that $\alpha_{26}^{i}$ correctly indicates a positive sign but $\alpha_{22}^{i}$ would indicate a negative sign, the resulting $\beta_{23}^{i+1}$ would have been assumed to be negative in its sign as well. Thus, when determining a decoded codeword $\hat{x}$ according to equation (6) a wrong codeword $\hat{x}$ may be obtained if one or several of the $\beta_{mn}^{i+1}$ elements are corrupted in a similar manner.

Exclusion sets may be defined in order to exclude data from the equations (or decoding process) which are assumed to be wrong, or which are highly likely to be wrong. Another possible definition criterion may be whether a message matrix element or value may provide a contribution to the decision process. E.g. if an LLR value is close to 0, this means that both events represented by this LLR are almost equally likely, such that no information (or only little to be correct) may be obtained from this value with regard to the correct decoding of a codeword.

If such data is included, the produced output is likely to be wrong as well. Therefore the present invention proposes to neglect such values from the equations as disclosed above.

As mentioned above, the exclusion sets for the new horizontal and vertical steps should be defined such that unreliable messages are excluded from the calculations. It should be obvious to those skilled in the art that the exclusion sets may be defined independently from each other. In other words an element of exclusion set $\Gamma_{mn}$ does not necessarily be element of exclusion set $\Omega_{mn}$.

Similarly the exclusion sets may be set independently in decoding iterations. Those skilled in the art will recognize that with increasing number of iterations, the overall reliability of messages passed may be increasing for reasonably good transmission conditions. Therefore with increasing number of iterations the number of elements of the exclusion sets may be reduced, such that at late stages of decoding the exclusion sets may be empty. It should be noted that the exclusion sets may depend both on the number of iterations processed so far, as well as on the maximum number of decoding iterations, which may be a parameter given by the communication system.

A list of possible criteria which may be used isolated or in combination for determining the exclusion sets is provided in the following. One parameter on which the reliability criterion deciding whether a message matrix element is comprised in exclusion set or not may be results from channel estimations. The channel conditions for each bit of a received codeword do not necessarily have to be similar, e.g. in case of employing OFDM (Orthogonal Frequency Division Multiplex). In such a system the different bits of a codeword may be transmitted on different subcarriers of a subcarrier set (channel). Hence, different channel conditions on the subcarriers may exist. As a measure for the channel conditions the SNR (Signal to Noise Ratio) or related quantities may be employed.

Another parameter on which a reliability criterion may be based on is the absolute values of the measures involved in the horizontal or vertical step, i.e. the log-likelihood ratio, the likelihood ratio, a likelihood difference, a log-likelihood difference, and/or another probability measure. As outlined above for LLR values, an absolute LLR value close to 0 may not provide any significant information for the decoding process.

As outlined above as well the iteration number of the decoding process may also provide a basis for a reliability criterion to determine the exclusion sets $\Gamma_{mn}$ and $\Omega_{mn}$. Another alternative basis may be a random process deciding which of the available message matrix elements should be included in the exclusion set, i.e. which of the message matrix parameters are excluded from the calculations in the horizontal and vertical steps.

It is further noted that the reconstruction of a codeword $\hat{x}$ may be performed after each horizontal step, such that the vertical step is only executed if the decoding procedure should be continued. Those skilled in the art will recognize that this is an implementational detail of the algorithm which does not affect the computational results.

As will be shown in the following section the ideas underlying the present invention may also be applied to decoding methods in which the calculations performed in the horizontal and/or vertical steps are based on a (log-) likelihood difference. Such a decoding method is for example known from WO 02/37731 A2. The exemplary system defined therein defines the horizontal step as:

$$r_{ik}(0) = \frac{1}{2}\left(1 + \prod_{l \neq k} \delta q_{il}\right) \tag{16}$$

$$r_{ik}(1) = \frac{1}{2}\left(1 - \prod_{l \neq k} \delta q_{il}\right) \tag{17}$$

and the vertical step as:

$$q_{ik}(0) = \alpha \cdot p_k(0) \prod_{j \neq i} r_{jk}(0) \tag{18}$$

$$q_{ik}(1) = \alpha \cdot p_k(1) \prod_{j \neq i} r_{jk}(1) \tag{19}$$

According to the present invention, a new horizontal and vertical step may be defined by:

$$r_{ik}(0) = \frac{1}{2}\left(1 + \prod_{\substack{l \neq k \\ l \in \Gamma_{ik}}} \delta q_{il}\right) \tag{20}$$

$$r_{ik}(1) = \frac{1}{2}\left(1 - \prod_{\substack{l \neq k \\ l \in \Gamma_{ik}}} \delta q_{il}\right) \tag{21}$$

for the horizontal step and by

$$q_{ik}(0) = \alpha \cdot p_k(0) \prod_{\substack{j \neq i \\ j \in \Omega_{ik}}} r_{jk}(0) \tag{22}$$

$$q_{ik}(1) = \alpha \cdot p_k(1) \prod_{\substack{j \neq i \\ j \in \Omega_{ik}}} r_{jk}(1) \qquad\qquad (23)$$

for the vertical step.

The notation used in this embodiment of the present invention above is similar to that of WO 02/37731 A2, except for the exclusion sets $\Gamma$ and $\Omega$, which are used as described in the present invention. $\delta q_{ik}$ refers to the difference between the probabilities that the i$^{th}$ element in the k$^{th}$ row is a "1" and a "0", i.e. $\delta q_{ik} = q_{ik}(I) - q_{ik}(0)$.

Further, $p_k(1)$ is the prior probability that the k$^{th}$ bit of the received codeword is a "1" (i.e. k=1..N). Accordingly, $p_k(0)$ is the prior probability that the k$^{th}$ bit of the received codeword is a "0". Hence, in the example algorithm given above, the two probabilities correspond to the initialization data $\lambda_n$, or in more detail $\lambda_n = \ln \dfrac{p_n(1)}{p_n(0)}$. In equations 16 through 23, $\alpha$ is a scaling factor chosen such that $q_{ik}(1) + q_{ik}(0) = 1$.

To decide whether a bit in the codeword is a "1" or a "0" the equation

$$\hat{x} = \begin{cases} 1 & for\ q_k(1) \geq q_k(0) \\ 0 & for\ q_k(1) < q_k(0) \end{cases} \qquad\qquad (24)$$

may be used where

$$q_k(0) = \alpha \cdot p_k(0) \cdot \prod_{j=1..M} r_{jk}(0) \qquad\qquad (25)$$

and

$$q_k(1) = \alpha \cdot p_k(1) \cdot \prod_{j=1..M} r_{jk}(1) \qquad\qquad (26).$$

After having discussed the underlying ideas of the present invention in detail, the following section will describe preferred embodiments of decoding processes of the present invention.

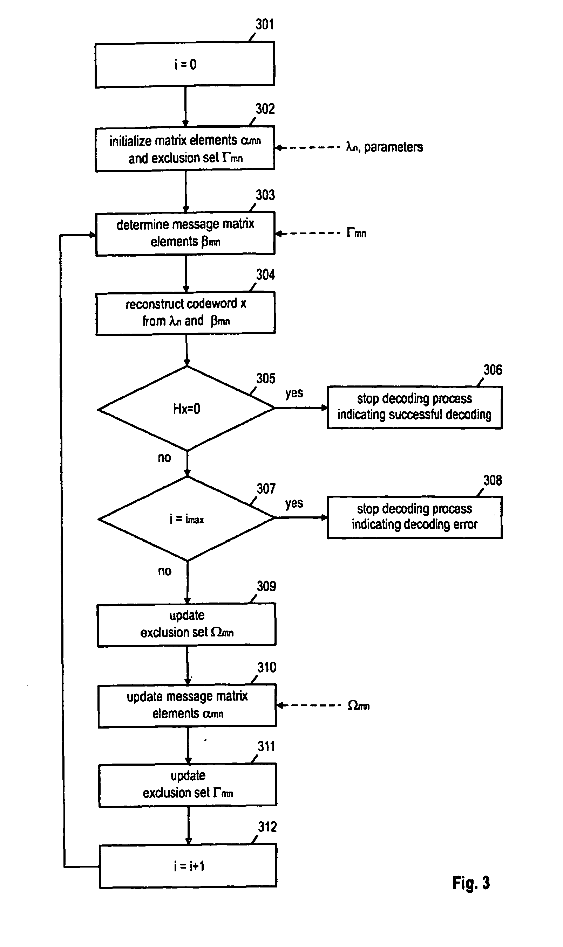

Fig. 3 shows a flow chart of an exemplary decoding process according to an embodiment of the present invention. In a fist step 301, a counter $i$ for counting the iteration of the decoding process may be initialized. Next, the message matrix elements $\alpha_{mn}$ may be initialized 302 e.g. by using the receiving means estimate of each codeword bit $\lambda_n$ in form of an LLR value and the exclusion set $\Gamma_{mn}$ may further be initialized based on parameters, e.g. a SNR value, indicating which of the codeword bits $\lambda_n$ fulfill a reliability criterion as defined in the previous sections. Optionally, in step 302 the exclusion set $\Omega_{mn}$ may further be initialized e.g. by defining an empty set or by including the elements of $\Gamma_{mn}$.

Taking the example of using likelihood differences as a probability measure, as described above, the initialization may be performed similarly. Instead of using the input data $\lambda_n$, the receiving section may provide the probabilities $p_k(0)$ and $p_k(1)$ which may be used to initialize the quantities $q_{ik}(0)$ and $q_{ik}(1)$. In this example decoding process $q_{ik}(0)$ and $q_{ik}(1)$ may be considered as corresponding to the usage of the message matrix elements $\alpha_{mn}$ during initialization.

Upon having initialized the message matrix elements $\alpha_{mn}$ and the exclusion set $\Gamma_{mn}$, the message matrix elements $\beta_{mn}$ of the horizontal step may be calculated 303 according to one of the equations (13) or (14) while taking into account the exclusion set $\Gamma_{mn}$.

When using likelihood differences as a probability measure, step 303 may correspond to determining the measures $r_{ik}(0)$ and $r_{ik}(1)$ as suggested by equations (20) and (21), under consideration of the exclusion set $\Gamma_{mn}$.

According to this embodiment of the present invention, the decoder may next try to reconstruct the received codeword $\hat{x}$, e.g. by using equation (6). Accordingly, equation (24) may be used when employing likelihood differences.

Next, it may be checked whether the reconstructed codeword $\hat{x}$ satisfies 305 the parity equations, e.g. by checking whether $H\hat{x} = 0$. If all parity check equations are satisfied, the decoding process may be stopped 306 and the successfully reconstructed codeword $\hat{x}$ may be provided to a further processing entity in the decoder. If at least one of the parity check equations is not satisfied, it may be determined if the maximum number of iterations as been reached 307. If so, the decoding process may be stopped 308 and a decoding error may be indicated.

If the number of iterations has not reached $i_{max}$ the exclusion set $\Omega_{mn}$ may be determined 309 based on the calculated message matrix elements $\beta_{mn}$ and/or the respective reliability criterion for each/the message matrix element/s.

Using the determined exclusion set $\Omega_{mn}$ new message matrix elements $\alpha_{mn}$ may be calculated 310 based on equation (15), which corresponds to the vertical step. When employing likelihood differences, equations (20) and (21) may be used to calculate the new $r_{ik}(0)$ and $r_{ik}(1)$ values.

Upon having determined the new message matrix elements $\alpha_{mn}$ (or the new $r_{ik}(0)$ and $r_{ik}(1)$ values) the exclusion set $\Gamma_{mn}$ may be updated 311 accordingly. Upon incrementing the iteration counter 312, the processing may continue by calculating new $\beta_{mn}$ values as outlined above (see step 303).

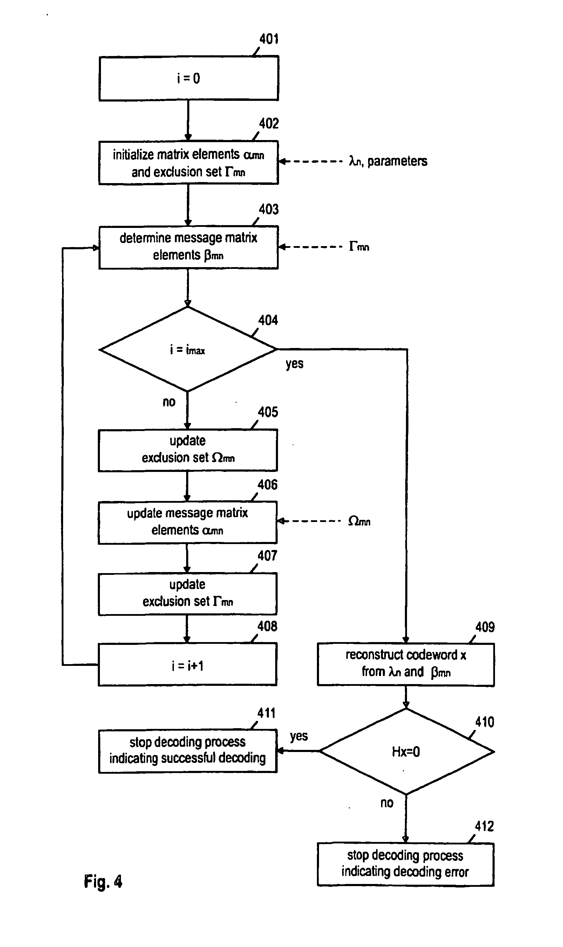

Next, a further embodiment of a decoding process of the present invention will be outlined in reference to Fig. 4. Fig. 4 shows a flow chart of another exemplary decoding process according to an embodiment of the present invention. The initialization of the decoder as shown in steps 401 and 402 correspond to those known from Fig. 3 (see steps 301, 302). Also the calculation of the $\beta_{mn}$ in step 403 may be identical to step 303 of Fig. 3.

In contrast to the decoding process known from Fig. 3, the decoder does not try to reconstruct a decoded codeword $\hat{x}$ in each iteration step, but a number of iterations are performed (see steps 403 to 408) first before trying to reconstruct codeword $\hat{x}$ 409.

Upon having calculated the $\beta_{mn}$ in step 403, it may be determined if the maximum number of iterations as been reached 404. If so, the decoding process may jump to step 409.

If the number of iterations has not reached $i_{max}$ the exclusion set $\Omega_{mn}$ may be determined 405 based on the calculated message matrix elements $\beta_{mn}$ and/or the respective reliability criterion for each/the message matrix element/s.

Using the determined exclusion set $\Omega_{mn}$ new message matrix elements $\alpha_{mn}$ may be calculated 406 based on equation (15), which corresponds to the vertical step. When employing likelihood differences, equations (20) and (21) may be used to calculate the new $r_{ik}(0)$ and $r_{ik}(1)$ values.

Upon having determined the new message matrix elements $\alpha_{mn}$ (or the new $r_{il}(0)$ and $r_{ik}(1)$ values) the exclusion set $\Gamma_{mn}$ may be updated 407 accordingly. Upon incrementing the iteration counter 408, the processing may continue by calculating new $\beta_{mn}$ values as outlined above (see step 403).

When exiting the iteration loop, i.e. when the iteration number i equals $i_{max}$, the decoder may reconstruct a codeword $\hat{x}$ 409. Further, it may be checked 410 if the reconstructed codeword $\hat{x}$ fulfills the parity check equations represented by parity check matrix H.

If all parity check equations are satisfied, the decoding process may be stopped 411 and the successfully reconstructed codeword $\hat{x}$ may be provided to a further processing entity in the decoder.

If at least one of the parity check equations is not satisfied, the decoding process may be stopped 308 and a decoding error may be indicated. Alternatively, the counter i may be reset and the maximum number of iterations may be reconfigured $i_{max}$ and further iterations according to steps 403 to 408 may be performed, before trying to reconstruct a codeword $\hat{x}$ again.

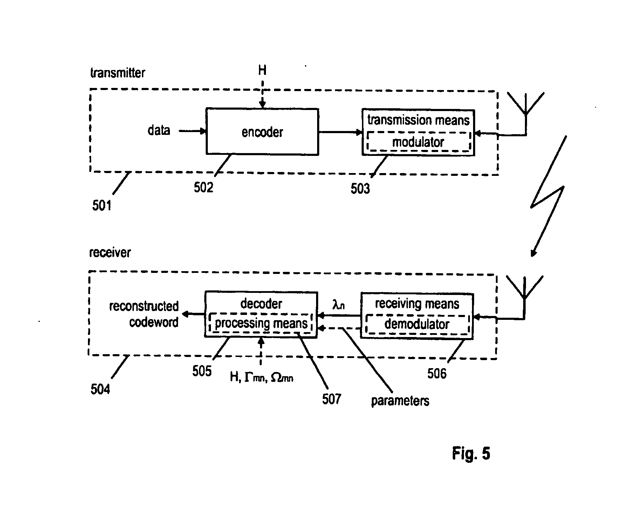

Next, Fig. 5 will be discussed in more detail. Fig. 5 shows a transmitter and a receiver unit according to an embodiment of the present invention. The transmitter 501 comprises an encoder 502 and a transmission means 503. The transmission means may comprise a modulator for modulating the signals encoded by encoder 502. As indicated by the dotted arrow, the encoder 502 is capable of encoding input data into codeword suitable for decoding according to the various embodiments of the decoding process. The modulated data may be transmitted by the transmission means 503 using an antenna as indicated.

The receiver 504 receiving the encoded signals may comprise a receiving means 506, which may comprise a demodulator for demodulating the received signals. Upon extracting the $\lambda_n$ values and parameters in the receiving means 506, these data may be provided to a decoder 505, which will consider the data to initialize the decoding process as outlined above.

The decoder 505 may comprise a processing means 507, adapted to decode the received data according to the methods described to produce reconstructed codewords.

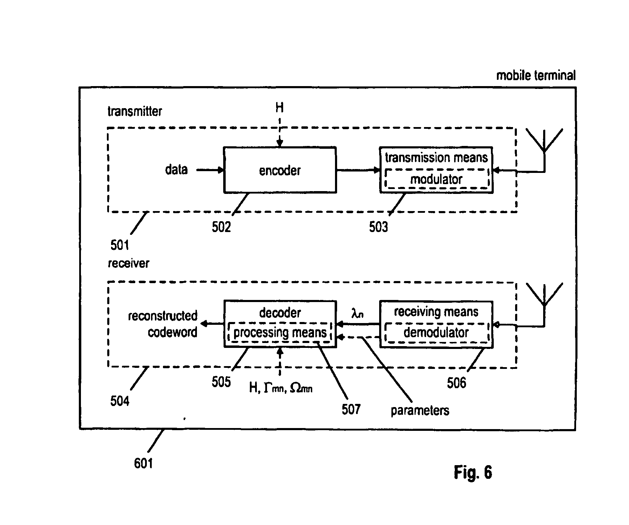

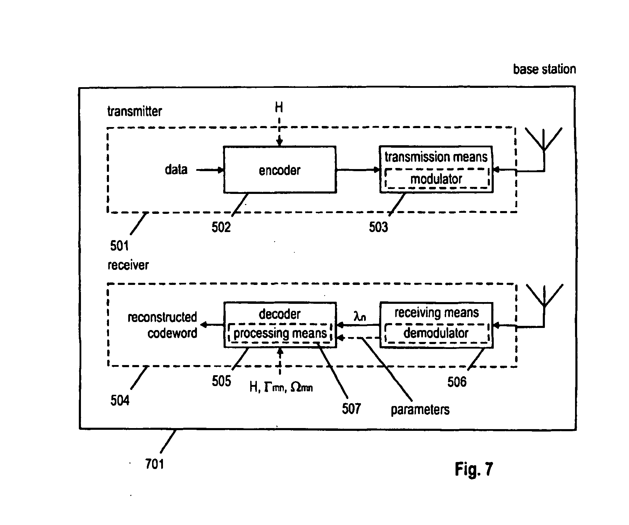

Fig. 6 and 7 show a mobile terminal 601 and a base station (Node B) 701 according to different embodiments of the present invention, respectively. The mobile terminal 601 and the base station may each include a transmitter 501 and a receiver 504 as shown in Fig. 5 to perform communications.

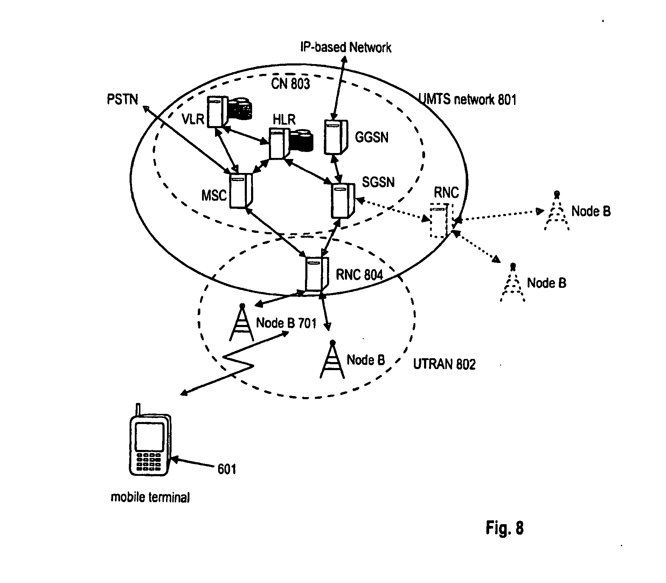

Fig. 8 shows an architectural overview of a communication system according to an embodiment of the present invention comprising a mobile terminal 601 shown in Fig. 6 and a base station (Node B) 701 shown in Fig. 7.

The overview depicts a UMTS network 801, which comprises a core network (CN) 803 and the UMTS terrestrial radio access network (UTRAN) 802. The mobile terminal 601 may be connected to the UTRAN 802 via a wireless link to a Node B 701. The base stations in the UTRAN 802 may be further connected to a radio network controller (RNC) 804. The CN 803 may comprise a (Gateway) Mobile Switching Center (MSC) for connecting the CN 803 to a Public Switched Telephone Network (PSTN). The Home Location Register (HLR) and the Visitor Location Register (VLR) may be used to store user related information. Further, the core network may also provide connection to an Internet Protocol-based (IP-based) network through the Serving GPRS Support Node (SGSN) and the Gateway GPRS Support Node (GGSN).

**Claims**

1. A method for decoding at least one codeword comprising n code bits in a decoder, the decoding being performed as message passing on a graph representation of the used code, wherein the graph representation is based on a parity check matrix, the method comprising the steps of:

   a) for each non-zero entry in a parity check matrix, initializing (302) the message matrix elements of a first message matrix with data obtained from a demodulator,
   b) for each non-zero entry in the parity check matrix, determining (303) the message matrix elements of a second message matrix based on message matrix elements of said first message matrix,
   c) reconstructing (304) a decoded codeword based on the data obtained from the demodulator and the message matrix elements of the second message matrix, and
   d) for each non-zero entry in the parity check matrix, updating (310) the message matrix elements of the first message matrix based on message matrix elements of the second message matrix,

   wherein a subset of message matrix elements of said second message matrix is used to update a message matrix element of said first message matrix and the message matrix elements of said subset fulfill (309) a first reliability criterion,
   **characterized by**
   further comprising the step of performing iterations by repeating steps b) and d).

2. The method according to claim 1, **characterized in that** a subset of message matrix elements of said first message matrix is used for determining a message matrix element of said second message matrix, wherein the message matrix elements of said subset fulfill (311) a second reliability criterion.

3. The method according to claim 2, wherein the first or second reliability criterion is redefined in at least one of the iteration steps.

4. The method according to one of claims 1 to 3, **characterized in that** the step of performing iterations further comprises the step of repeating step c).

5. The method according to one of claims 1 to 4, **characterized by** further comprising the step of:

   e) checking (305) whether parity check equations of the parity-check matrix are satisfied by the reconstructed codeword.

6. The method according to claim 1 to 5, **characterized in that** the iteration is stopped (306, 308) upon reaching on predetermined number of iterations or in case the decoded codeword satisfies the parity check equations.

7. The method according to one of claims 1 to 6, **characterized in that** the data obtained from a demodulator comprises parameters representing one of a likelihood ratio, a likelihood difference or a probability for each of the n code bits of a codeword.

8. The method according to claim 7, **characterized in that** the data obtained from the demodulator further comprises indications which of the parameters fulfill the reliability criterion.

9. The method according to one of claims 1 to 8, **characterized by** further comprising the step of updating the subset of message matrix elements of said second message matrix used to determine the message matrix element of said first message matrix upon determining new message matrix elements of said second message matrix in one of said iteration steps.

10. The method according to claim 9, **characterized in that** in the step of updating the subset of message matrix elements of said second message matrix, the updated subset comprises only message matrix elements of the second message matrix fulfilling the second reliability criterion.

11. The method according to one of claims 1 to 10, **characterized by** further comprising the step of updating the subset of message matrix elements of said first message matrix used to determine the message matrix element of said second message matrix upon determining new message matrix elements of said first message matrix in one of said iteration steps.

12. The method according to claim 11, **characterized in that** in the step of updating the subset of message matrix elements of said first message matrix, the updated subset comprises only message matrix elements of the first message matrix fulfilling the first reliability criterion.

13. The method according to one of claims 1 to 12, **characterized in that** the first or second reliability criterion is based on at least one of channel estimations of a radio channel via which the codeword has been received, the absolute values of the elements of the first and/or second message matrix, the absolute values of the data provided by the demodulator, the number of iterations in the decoding which have already been processed, the maximum number of iterations to be performed in the decoding process, and a random process.

14. The method according to claim 13, **characterized in that** the second/first reliability criterion is not fulfilled by a message matrix element of the first/second message matrix, if the signal to noise ratio for the element and/or the absolute value of the element is below a predetermined threshold value.

15. The method according to one of claims 1 to 14, **characterized in that** the error correcting code is a low-density parity-check code.

16. A decoder (505) for decoding at least one codeword, the decoding being performed as message passing on a graph representation of the used code, wherein the graph representation is based on a parity check matrix, the decoder comprising processing means adapted to perform the following steps :

 a) for each non-zero entry in a parity check matrix, initializing the message matrix elements of a first message matrix with data obtained from a demodulator,
 b) for each non-zero entry in the parity check matrix, determining the message matrix elements of a second message matrix based on message matrix elements of said first message matrix,
 c) reconstructing a decoded codeword based on the data obtained from the demodulator and the message matrix elements of the second message matrix, and
 d) for each non-zero entry in the parity check matrix, updating the message matrix elements of the first message matrix based on message matrix elements of the second message matrix,

wherein a subset of message matrix elements of said second message matrix is used to update a message matrix element of said first message matrix, wherein the message matrix elements of said subset fulfill a first reliability criterion,
**characterized in that**
the processing means is adapted to perform iterations by repeating steps b) and d).

17. The decoder according to claim 16 or 17, **characterized in that** the decoder is adapted to perform the method according to one of claims 2 to 15.

18. A mobile terminal (601) for a mobile communication system, comprising:

 receiving means (506) for receiving at least one codeword,
 a decoder (505) being configured according to claim 16 or 17, and
 demodulation means for demodulating the at least one received codeword and for providing data to said decoder.

19. The mobile terminal according to claim 18, **characterized by** further comprising coding means (502) for encoding data in at least one codeword, and transmission means (503) for transmitting the at least one codeword, and in that at least one transmitted codeword is suitable for decoding according to a method of one of claims 1 to 15.

20. A base station (701) for a mobile communication system, comprising:

receiving means (506) for receiving at least one codeword,
a decoder (505) being configured according to claim 16 or 17, and
demodulation means for demodulating the at least one received codeword and for delivering data to said decoder.

21. The base station according to claim 20, **characterized by** further comprising coding means (502) for encoding data in at least one codeword, and transmission means (503) for transmitting the at least one codeword, and in that at least one transmitted codeword is suitable for decoding according to a method of one of claims 1 to 15.

22. A mobile communication system comprising at least one base station according to claim 20 or 21 and at least one mobile terminal according to claim 18 or 19.

**Patentansprüche**

1. Verfahren zum Decodieren wenigstens eines Codeworts, das n Code-Bits umfasst, in einem Decoder, wobei das Decodieren als Message-Passing auf einer Darstellung des verwendeten Codes als Graph durchgeführt wird, wobei die Darstellung als Graph auf einer Paritätsprüfungs-Matrix basiert und das Verfahren die folgenden Schritte umfasst:

a) für jeden von Null verschiedenen Eintrag in einer Paritätsprüfungs-Matrix, Initialisieren (302) der Nachrichten-Matrixelemente einer ersten Nachrichten-Matrix mit von einem Demodulator bezogenen Daten,
b) für jeden von Null verschiedenen Eintrag in der Paritätsprüfungs-Matrix, Bestimmen (303) der Nachrichten-Matrixelemente einer zweiten Nachrichten-Matrix auf Basis von Nachrichten-Matrixelementen der ersten Nachrichten-Matrix,
c) Rekonstruieren (304) eines decodierten Codeworts auf Basis der von dem Demodulator bezogenen Daten und der Nachrichten-Matrixelemente der zweiten Nachrichten-Matrix, und
d) für jeden von Null verschiedenen Eintrag der Paritätsprüfungs-Matrix, Aktualisieren (310) der Nachrichten-Matrixelemente in der ersten Nachrichten-Matrix auf Basis von Nachrichten-Matrixelementen der zweiten Nachrichten-Matrix,

wobei eine Teilmenge von Nachrichten-Matrixelementen in der zweiten Nachrichten-Matrix verwendet wird, um ein Nachrichten-Matrixelement der ersten Nachrichten-Matrix zu aktualisieren, und die Nachrichten-Matrixelemente der Teilmenge ein erstes Zuverlässigkeitskriterium erfüllen (309),
**dadurch gekennzeichnet, dass**
es des Weiteren den Schritt des Durchführens von Iterationen durch Wiederholen der Schritte b) und d) umfasst.

2. Verfahren nach Anspruch 1, **dadurch gekennzeichnet, dass** eine Teilmenge von Nachrichten-Matrixelementen der ersten Nachrichten-Matrix verwendet wird, um ein Nachrichten-Matrixelement der zweiten Nachrichten-Matrix zu bestimmen, wobei die Nachrichten-Matrixelemente der Teilmenge ein zweites Zuverlässigkeitskriterium erfüllen (311).

3. Verfahren nach Anspruch 2, wobei das erste oder das zweite Zuverlässigkeitskriterium in wenigstens einem der Iterationsschritte neu definiert wird.

4. Verfahren nach einem der Ansprüche 1 bis 3, **dadurch gekennzeichnet, dass** der Schritt des Durchführens von Iterationen des Weiteren den Schritt des Wiederholens von Schritt c) umfasst.

5. Verfahren nach einem der Ansprüche 1 bis 4, **dadurch gekennzeichnet, dass** es des Weiteren den folgenden Schritt umfasst:

e) Prüfen (305), ob Paritätsprüfungs-Gleichungen der Paritätsprüfungs-Matrix durch das rekonstruierte Codewort erfüllt werden.

6. Verfahren nach einem der Ansprüche 1 bis 5, **dadurch gekennzeichnet, dass** die Iteration beim Erreichen einer vorgegebenen Anzahl der Iterationen oder in dem Fall, dass das decodierte Codewort die Paritätsprüfungs-Gleichungen erfüllt, unterbrochen wird (306, 308).

**7.** Verfahren nach einem der Ansprüche 1 bis 6, **dadurch gekennzeichnet, dass** die von einem Demodulator ermittelten Daten Parameter umfassen, die ein Wahrscheinlichkeits-Verhältnis, eine Wahrscheinlichkeits-Differenz oder eine Wahrscheinlichkeit für jedes der n Codebits eines Codeworts darstellen.

**8.** Verfahren nach Anspruch 7, **dadurch gekennzeichnet, dass** die von dem Demodulator ermittelten Daten des Weiteren Anzeigen dahingehend umfassen, welche der Parameter das Zuverlässigkeitskriterium erfüllen.

**9.** Verfahren nach einem der Ansprüche 1 bis 8, **dadurch gekennzeichnet, dass** es des Weiteren den Schritt des Aktualisierens der Teilmenge von Nachrichten-Matrixelementen der zweiten Nachrichten-Matrix, die verwendet werden, um das Nachrichten-Matrixelement der ersten Nachrichten-Matrix zu bestimmen, nach Bestimmen neuer Nachrichten-Matrixelemente der zweiten Nachrichten-Matrix in einem der Iterationsschritte umfasst.

**10.** Verfahren nach Anspruch 9, **dadurch gekennzeichnet, dass** in dem Schritt des Aktualisierens der Teilmenge von Nachrichten-Matrixelementen der zweiten Nachrichten-Matrix die aktualisierte Teilmenge nur Nachrichten-Matrixelemente der zweiten Nachrichten-Matrix umfasst, die das zweite Zuverlässigkeitskriterium erfüllen.

**11.** Verfahren nach einem der Ansprüche 1 bis 10, **dadurch gekennzeichnet, dass** es des Weiteren den Schritt des Aktualisierens der Teilmenge von Nachrichten-Matrixelementen der ersten Nachrichten-Matrix, die zum Bestimmen des Nachrichten-Matrixelementes der zweiten Nachrichten-Matrix verwendet werden, nach Bestimmen neuer Nachrichten-Matrixelemente der ersten Nachrichten-Matrix in einem der Iterationsschritte umfasst.

**12.** Verfahren nach Anspruch 11, **dadurch gekennzeichnet, dass** in dem Schritt des Aktualisierens der Teilmenge von Nachrichten-Matrixelementen der ersten Nachrichten-Matrix die aktualisierte Teilmenge nur Nachrichten-Matrixelemente der ersten Nachrichten-Matrix umfasst, die das Zuverlässigkeitskriterium erfüllen.

**13.** Verfahren nach einem der Ansprüche 1 bis 12, **dadurch gekennzeichnet, dass** das erste oder zweite Zuverlässigkeitskriterium wenigstens auf Kanal-Schätzungen eines Funkkanals, über den das Codewort empfangen worden ist, den Absolutwerten der Elemente der ersten und/oder zweiten Nachrichten-Matrix, den Absolutwerten der durch den Demodulator bereitgestellten Daten, der Anzahl von Iterationen beim Decodieren, die bereits durchgeführt worden sind, der maximalen Anzahl von Iterationen, die bei dem Decodierprozess durchzuführen sind, oder einem Zufallsprozess basiert.

**14.** Verfahren nach Anspruch 13, **dadurch gekennzeichnet, dass** das zweite/erste Zuverlässigkeitskriterium durch ein Nachrichten Matrixelement der ersten/zweiten Nachrichten-Matrix nicht erfüllt wird, wenn das Signal-Rausch-Verhältnis für das Elemente und/oder der Absolutwert des Elementes unter einem vorgegebenen Schwellenwert liegen/liegt.

**15.** Verfahren nach einem der Ansprüche 1 bis 14, **dadurch gekennzeichnet, dass** der Fehlerkorrekturcode ein LDPE-Code ist.

**16.** Decoder (505) zum Decodieren wenigstens eines Codeworts, wobei das Decodieren als Message-Passing auf einer Darstellung des verwendeten Codes als Graph durchgeführt wird und die Darstellung als Graph auf einer Paritätsprüfungs-Matrix basiert, und der Decoder eine Verarbeitungseinrichtung umfasst, die so ausgeführt ist, dass sie die folgenden Schritte durchführt:

a) für jeden von Null verschiedenen Eintrag in einer Paritätsprüfungsmatrix, Initialisieren der Nachrichten-Matrixelemente einer ersten Nachrichten-Matrix mit von einem Demodulator bezogenen Daten,
b) für jeden von Null verschiedenen Eintrag in der Paritätsprüfungs-Matrix, Bestimmen der Nachrichten-Matrixelemente einer zweiten Nachrichten-Matrix auf Basis von Nachrichten-Matrixelementen der ersten Nachrichten-Matrix,
c) Rekonstruieren eines decodierten Codeworts auf Basis der von dem Demodulator bezogenen Daten und der Nachrichten-Matrixelemente der zweiten Nachrichten-Matrix, und
d) für jeden von Null verschiedenen Eintrag in der Paritätsprüfungs-Matrix Aktualisieren der Nachrichten-Matrixelemente in der ersten Nachrichten-Matrix auf Basis von Nachrichten-Matrixelementen der zweiten Nachrichten-Matrix,

wobei eine Teilmenge von Nachrichten-Matrixelementen der zweiten Nachrichten-Matrix verwendet wird, um ein Nachrichten-Matrixelement der ersten Nachrichten-Matrix zu aktualisieren und die Nachrichten-Matrixelemente der Teilmenge ein erstes Zuverlässigkeitskriterium erfüllen,

**dadurch gekennzeichnet, dass**

die Verarbeitungseinrichtung so eingerichtet ist, dass sie Iterationen durchführt, indem sie Schritte b) und d) wiederholt.

**17.** Decoder nach Anspruch 16 oder 17, **dadurch gekennzeichnet, dass** der Decoder so eingerichtet ist, dass er das Verfahren nach einem der Ansprüche 2 bis 15 durchführt.

**18.** Ein mobiles Endgerät (601) für ein Mobil-Kommunikationssystem, das umfasst:

eine Empfangseinrichtung (506) zum Empfangen wenigstens eines Codeworts,
einen Decoder (505), der nach Anspruch 16 oder 17 konfiguriert ist; und
eine Demodulationseinrichtung zum Demodulieren des wenigstens einen empfangenen Codeworts und zum Bereitstellen von Daten für den Decoder.

**19.** Das mobile Endgerät nach Anspruch 18, **dadurch gekennzeichnet, dass** es des Weiteren eine Codiereinrichtung (502) zum Codieren von Daten in wenigstens einem Codewort und eine Sendeeinrichtung (503) zum Senden des wenigstens einen Codeworts umfasst, und **dadurch**, dass wenigstens ein gesendetes Codewort zum Decodieren gemäß einem Verfahren nach einem der Ansprüche 1 bis 15 geeignet ist.

**20.** Basisstation (701) für ein Mobil-Kommunikationssystem, die umfasst:

eine Empfangseinrichtung (506) zum Empfangen wenigstens eines Codeworts,
einen Decoder (505), der nach Anspruch 16 oder 17 konfiguriert ist, und
eine Demodulationseinrichtung zum Demodulieren des wenigstens einen empfangenen Codeworts und zum Zuführen von Daten zu dem Decoder.

**21.** Basisstation nach Anspruch 20, **dadurch gekennzeichnet, dass** sie des Weiteren eine Codiereinrichtung (502) zum Codieren von Daten in wenigstens einem Codewort und eine Sendeeinrichtung (503) zum Senden des wenigstens einen Codeworts umfasst, und dass wenigstens ein gesendetes Codewort zum Decodieren gemäß einem Verfahren nach einem der Ansprüche 1 bis 15 geeignet ist.

**22.** Mobil-Kommunikationssystem, das wenigstens eine Basisstation nach Anspruch 20 oder 21 und wenigstens ein Mobil-Endgerät nach Anspruch 18 oder 19 umfasst.

**Revendications**

**1.** Procédé pour décoder au moins un mot de code comprenant n bits de code dans un décodeur, le décodage étant exécuté comme passage de messages sur une représentation graphique du code utilisé, dans lequel la représentation graphique est basée sur une matrice de vérification de parité, le procédé comprenant les étapes de:

(a) pour chaque entrée non nulle dans une matrice de vérification de parité, initialiser (302) les éléments de matrice de messages d'une première matrice de messages avec des données obtenues à partir d'un démodulateur,
(b) pour chaque entrée non nulle dans la matrice de vérification de parité, déterminer (303) les éléments de matrice de messages d'une deuxième matrice de messages sur la base d'éléments de matrice de messages de ladite première matrice de messages,
(c) reconstruire (304) un mot de code décodé sur la base des données obtenues à partir du démodulateur et des éléments de matrice de messages de la deuxième matrice de messages, et
(d) pour chaque entrée non nulle dans la matrice de vérification de parité, mettre à jour (310) les éléments de matrice de messages de la première matrice de messages sur la base d'éléments de matrice de messages de la deuxième matrice de messages,

où un sous ensemble d'éléments de matrice de messages de ladite deuxième matrice de messages est utilisé afin de mettre à jour un élément de matrice de messages de ladite première matrice de messages et les éléments de matrice de messages dudit sous ensemble remplissent (309) un premier critère de fiabilité,
**caractérisé par**
comprenant en plus les étapes consistant à exécuter des itérations en répétant les étapes b) et d).

2. Procédé selon la revendication selon la revendication 1, **caractérisé en ce qu'**un sous ensemble d'éléments de matrice de messages de ladite première matrice de messages est utilisé pour déterminer un élément de matrice de messages de ladite deuxième matrice de messages, dans lequel les éléments de matrice de messages dudit sous ensemble remplissent (311) un deuxième critère de fiabilité.

3. Procédé selon la revendication 2, dans lequel le premier ou le deuxième critère de fiabilité est redéfini dans au moins l'une des étapes d'itération.

4. Procédé selon l'une des revendications 1 à 3, **caractérisé en ce que** l'étape d'exécution d'itérations comprend de plus l'étape de répétition de l'étape c).

5. Procédé selon l'une des revendications 1 à 4, **caractérisé par** le fait de comprendre en plus l'étape de:

   e) vérifier (305) si des équations de vérification de parité de la matrice de vérification de parité sont satisfaites par le mot de code reconstruit.

6. Procédé selon les revendications 1 à 5, **caractérisé en ce que** l'itération est arrêtée (306, 308) lorsque l'on atteint un nombre prédéterminé d'itérations ou dans le cas où le mot de code décodé satisfait les équations de vérification de parité.

7. Procédé selon l'une des revendications 1 à 6, **caractérisé en ce que** les données obtenues à partir d'un démodulateur comprennent des paramètres représentant l'un d'un rapport de vraisemblance, d'une différence de vraisemblance ou d'une probabilité pour chacun des n bits de code d'un mot de code.

8. Procédé selon la revendication 7, **caractérisé en ce que** les données obtenues à partir du démodulateur comprennent en plus des indications concernant lequel des paramètres remplit le critère de fiabilité.

9. Procédé selon l'une des revendications 1 à 8, **caractérisé par** le fait de comprendre en plus l'étape de mise à jour du sous ensemble d'éléments de matrice de messages de ladite deuxième matrice de messages utilisés pour déterminer l'élément de matrice de messages de ladite première matrice de messages après la détermination de nouveaux éléments de matrice de messages de ladite deuxième matrice de messages dans l'une desdites étapes d'itération.

10. Procédé selon la revendication 9, **caractérisé en ce que** dans l'étape de mise à jour du sous ensemble d'éléments de matrice de messages de ladite deuxième matrice de messages, le sous ensemble mis à jour comprend uniquement des éléments de matrice de messages de la deuxième matrice de messages remplissant le deuxième critère de fiabilité.

11. Procédé selon l'une des revendications 1 à 10, **caractérisé par** le fait de comprendre en plus l'étape de mise à jour du sous ensemble d'éléments de matrice de messages de ladite première matrice de messages utilisés pour déterminer l'élément de matrice de messages de ladite deuxième matrice de messages après la détermination de nouveaux éléments de matrice de messages de ladite première matrice de messages dans l'une desdites étapes d'itération.

12. Procédé selon la revendication 11, **caractérisé en ce que** l'étape de mise à jour du sous ensemble d'éléments de matrice de messages de ladite première matrice de messages, le sous ensemble mis à jour comprend uniquement des éléments de matrice de messages de la première matrice de messages remplissant le premier critère de fiabilité.

13. Procédé selon l'une des revendications 1 à 12, **caractérisé en ce que** le premier ou le deuxième critère de fiabilité est basé sur au moins l'une d'estimations de canal d'un canal radio par le biais duquel le mot de code a été reçu, des valeurs absolues des éléments de la première et/ou deuxième matrice de messages, des valeurs absolues des données pourvues par le démodulateur, du nombre d'itérations dans le décodage qui out déjà été effectuées, du nombre maximal d'itérations à exécuter dans le processus de décodage, et d'un processus aléatoire.

**14.** Procédé selon la revendication 13, **caractérisé en ce que** le premier/deuxième critère de fiabilité n'est pas rempli par un élément de matrice de messages de la première/deuxième matrice de messages, si le rapport signal sur bruit pour l'élément et/ou la valeur absolue de l'élément est en-dessous d'une valeur seuil prédéterminée.

**15.** Procédé selon l'une des revendications 1 à 14, **caractérisé en ce que** le code de correction d'erreur est un code de vérification de parité à faible densité.

**16.** Décodeur (505) pour décoder au moins un mot de code, le décodage étant exécuté comme passage de messages sur une représentation graphique du code utilisé, dans lequel la représentation graphique est basée sur une matrice de vérification de parité, le décodeur comprenant un moyen de traitement adapté pour exécuter les étapes suivantes:

a) pour chaque entrée non nulle dans une matrice de vérification de parité, initialiser les éléments de matrice de messages d'une première matrice de messages avec des données obtenues à partir d'un démodulateur,
b) pour chaque entrée non nulle dans la matrice de vérification de parité, déterminer les éléments de matrice de messages d'une deuxième matrice de messages sur la base d'éléments de matrice de messages de ladite première matrice de messages,
c) reconstruire un mot de code décodé sur la base des données obtenues à partir du démodulateur et des éléments de matrice de messages de la deuxième matrice de messages, et
d) pour chaque entrée non nulle dans la matrice de vérification de parité, mettre à jour les éléments de matrice de messages de la première matrice de messages sur la base d'éléments de matrice de messages de la deuxième matrice de messages,

dans lequel un sous ensemble d'éléments de matrice de messages de ladite deuxième matrice de messages est utilisé afin de mettre à jour un élément de matrice de messages de ladite première matrice de messages, où les éléments de matrice de messages dudit sous ensemble remplissent un premier critère de fiabilité,
**caractérisé en ce que**
le moyen de traitement est adapté pour exécuter des itérations en répétant les étapes b) et d).

**17.** Décodeur selon la revendication 16 ou 17, **caractérisé en ce que** le décodeur est adapté pour exécuter le procédé selon l'une des revendications 2 à 15.

**18.** Terminal mobile (601) pour un système de communication mobile, comprenant:

un moyen de réception (506) pour recevoir au moins un mot de code,
un décodeur (505) étant configuré selon la revendication 16 ou 17, et
un moyen de démodulation pour démoduler le au moins un mot de code reçu et pour fournir des données audit décodeur.

**19.** Terminal mobile selon la revendication 18, **caractérisé par** le fait de comprendre en plus un moyen de codage (502) pour coder des données en au moins un mot de code, et un moyen de transmission (503) pour transmettre le au moins un mot de code, et en ce qu'au moins un mot de code transmis est adéquat pour un décodage selon un procédé de l'une des revendications 1 à 15.

**20.** Station de base (701) pour un système de communication mobile, comprenant:

un moyen de réception (506) pour recevoir au moins un mot de code,
un décodeur (505) étant configuré selon la revendication 16 ou 17, et
un moyen de démodulation pour démoduler le au moins un mot de code reçu et pour livrer des données audit décodeur.

**21.** Station de base selon la revendication 20, **caractérisée par** le fait de comprendre en plus un moyen de codage (502) pour coder des données en au moins un mot de code, et un moyen de transmission (503) pour transmettre le au moins un mot de code, et en ce qu'au moins un mot de code transmis est adéquat pour un décodage selon un procédé de l'une des revendications 1 à 15.

**22.** Système de communication mobile comprenant au moins une station de base selon la revendication 20 ou 21 et au moins un terminal mobile selon la revendication 18 ou 19.

Fig. 1

**Fig. 2**

EP 1 687 902 B1

**301** — i = 0

**302** — initialize matrix elements $\alpha_{mn}$ and exclusion set $\Gamma_{mn}$ ◀------ $\lambda_n$, parameters

**303** — determine message matrix elements $\beta_{mn}$ ◀------ $\Gamma_{mn}$

**304** — reconstruct codeword x from $\lambda_n$ and $\beta_{mn}$

**305** — Hx=0 → yes → **306** stop decoding process indicating successful decoding

no

**307** — i = $i_{max}$ → yes → **308** stop decoding process indicating decoding error

no

**309** — update exclusion set $\Omega_{mn}$

**310** — update message matrix elements $\alpha_{mn}$ ◀------ $\Omega_{mn}$

**311** — update exclusion set $\Gamma_{mn}$

**312** — i = i+1

**Fig. 3**

23

401

i = 0

402

initialize matrix elements $\alpha_{mn}$ and exclusion set $\Gamma_{mn}$ ◁------- $\lambda_n$, parameters

403

determine message matrix elements $\beta_{mn}$ ◁------- $\Gamma_{mn}$

404

i = $i_{max}$

yes

no

405

update exclusion set $\Omega_{mn}$

406

update message matrix elements $\alpha_{mn}$ ◁------- $\Omega_{mn}$

407

update exclusion set $\Gamma_{mn}$

408

i = i+1

409

reconstruct codeword x from $\lambda_n$ and $\beta_{mn}$

411

stop decoding process indicating successful decoding

yes

410

Hx=0

no

412

stop decoding process indicating decoding error

Fig. 4

EP 1 687 902 B1

transmitter

H

data → | encoder | → | transmission means / modulator |

501 502 503

receiver

reconstructed codeword ← | decoder / processing means | ← $\lambda_n$ ← | receiving means / demodulator |

504 505 H, $\Gamma_{mn}$, $\Omega_{mn}$ 507 parameters 506

Fig. 5

Fig. 6

Fig. 7

Fig. 8

mobile terminal

601

Node B

UTRAN 802

Node B 701

Node B

RNC 804

Node B

RNC

SGSN

MSC

GGSN

HLR

VLR

PSTN

UMTS network 801

CN 803

IP-based Network

## REFERENCES CITED IN THE DESCRIPTION

**Patent documents cited in the description**

• WO 0237731 A2

**Non-patent literature cited in the description**

• **GALLAGER.** Low-density parity-check codes. *IRE Transactions on Information Theory,* 1962, vol. IT-8, 21-28
• **TANNER.** A recursive approach to low complexity code. *IEEE Transactions on Information Theory,* 1981, 533-547
• **MACKAY et al.** Near Shannon limit performance of Low-Density Parity-Check Codes. *IEEE Electronic Letters,* 1996, vol. 32, 1645-1646
• **DAVEY et al.** Low-Density Parity Check Codes for GF(q. *IEEE Communications Letters,* June 1998, vol. 2 (6
• **KSCHISCHANG et al.** Factor Graphs and the Sum-Product Algorithm. *IEEE Transactions on Information Theory,* February 2001, vol. 47 (2
• **NOUH et al.** Bootstrap Decoding of Low Density Parity-Check Codes. *IEEE Communications Letters,* September 2002, vol. 6 (9